# EUROPÄISCHE PATENTANMELDUNG

(11) **EP 3 267 339 A1**
(43) Veröffentlichungstag der Anmeldung: **10.01.2018**
(21) Anmeldenummer: 16178173.7
(22) Anmeldetag: 06.07.2016
(51) Int. Cl.: G06F 17/50, G06F 17/17

(54) **VERFAHREN ZUR ERSTELLUNG EINES META-MODELLS ZUR BERECHNUNG VON KERBSPANNUNGEN**

(71) Anmelder: Siemens AG Österreich, 1210 Wien (AT)
(72) Erfinder: Kittinger, Bernhard, 8020 Graz (AT)
(74) Vertreter: Maier, Daniel Oliver

(57) **Zusammenfassung**

Um die Berechnung von Kerbspannungen für eine Vielzahl von zu bewertenden Querschnitten bei verringertem Rechenaufwand und verringerter Fehleranfälligkeit zu ermöglichen, wird ein Verfahren zur Erstellung eines Meta-Modells zur Berechnung von Kerbspannungen für einen zu bewertenden Querschnitt (Q_{1...m}) einer Vielzahl an zumindest eine Schweißnaht (S) mit einer Kerbe aufweisenden Bauteilen (B_{1...m}) vorgeschlagen, wobei der zu bewertende Querschnitt (Q_{1...m}) jedes Bauteils (B_{1...m}) durch eine spezifische Kombination aus N den zu bewertenden Querschnitt (Q_{1...m}) das des Bauteils (B_{1...m}) charakterisierenden geometrischen Parametern (P_{1...N}) und deren konkrete Werte definiert ist,
wobei folgende Verfahrensschritte durchgeführt werden:
- Definition eines N-dimensionalen Parameterraums;
- Erstellen einer diskreten Anzahl an Querschnitts-Modellen;
- Berechnung von Kerbspannungs-Informationen für jedes Querschnitts-Modell als Funktionswert einer durch das jeweilige Querschnitts-Modell bestimmten Stützstelle;
- Erstellen des Meta-Modells in Form einer N-dimensionalen, vorzugsweise stetigen, Funktion, wobei die Funktionswerte des Meta-Modells an den Stützstellen an die Funktionswerte der Stützstellen selbst angenähert werden.

## Beschreibung

### Technisches Gebiet

Die Erfindung betrifft ein mittels eines Computers durchgeführtes Verfahren zur Erstellung eines Meta-Modells zur Berechnung von Kerbspannungen für einen zu bewertenden Querschnitt einer Vielzahl an zumindest eine Schweißnaht mit einer Kerbe aufweisenden Bauteilen, sowie ein Verfahren zur Ermittlung von Kerbspannungen mit einem erfindungsgemäß erstellten Meta-Modell, für ein zumindest einen zu bewertenden Querschnitt eines eine Schweißnaht mit einer Kerbe aufweisenden Bauteils, und ein Computerprogrammprodukt zur Durchführung des Verfahrens.

### Stand der Technik

Bei der Dimensionierung und Konstruktion eines eine Schweißnaht oder mehrere Schweißnähte aufweisenden Bauteils, wobei die Schweißnaht in der Regel mehrere Komponenten des Bauteils fügetechnisch miteinander verbindet, sind Parameter wie Schweißnaht-Typ oder Schweißnaht-Querschnitt, genauso relevant wie die relative Position der Komponenten des Bauteils zueinander. Die Berechnung erfolgt zumeist an einem zu bewertenden Querschnitt des Bauteils, der sich aus mehreren Komponenten wie Blechen zusammensetzt, und über eine spezifische Kombination von geometrischen Parametern, wie Blechstärke, Winkel, Länge und/oder Breite, definiert ist. Damit die Schweißnaht den im Betrieb wirkenden äußeren Lasten einerseits bei Spitzenbelastungen standhält und andererseits auch anhaltenden Belastungen über einen langen Zeitraum standhält, müssen neben den oben genannten Faktoren auch die Art der Krafteinwirkung, der Punkt bzw. die Fläche des Kraftangriffs und der Verlauf der Schweißnaht berücksichtigt werden.

Die modernste Methode zur Bewertung der Ermüdungsfestigkeit der Schweißnaht ist das Kerbspannungskonzept. Zur Anwendung dieses Kerbspannungskonzepts wird der zu bewertende Querschnitt des Bauteils üblicher Weise unabhängig von der tatsächlichen Anzahl der Komponenten so modelliert, dass er einstückig ausgebildet ist und auch die Schweißnaht selbst mitumfasst, wobei die lokalen Kerben an den Nahtübergängen und Wurzeln der Schweißnaht bzw. der Schweißnähte durch einen normierten Kerb-Radius modelliert bzw. abgebildet werden. Der Bewertung der Ermüdungsfestigkeit werden sodann die berechneten Kerbspannungen an potentiellen Riss-Ausgangsorten am Grund des Kerb-Radius zu Grunde gelegt.

Zur Auslegung von Schweiß-Bauteilen werden in der Regel computergestützte Berechnungen mittels Finite-Elemente-Methoden (FEM) durchgeführt, in denen in an sich bekannter Art und Weise ein zweidimensionales oder dreidimensionales Gitternetz des Bauteils bzw. des zu bewertenden Querschnitts erzeugt wird und mit einer definierten Last belastet wird. Aus diesem Gitternetz werden dann durch den physikalischen Zusammenhang zwischen Verschiebung und Spannung, etwa implementiert durch eine Steifigkeitsmatrix, die Spannungen in den Knotenpunkten des Gitternetzes über die Verschiebung der Knotenpunkte unter Einwirkung der äußeren Last berechnet. Auf die technischen Einzelheiten der Berechnung soll in der Folge nicht näher eingegangen werden, da es sich bei der FEM-Berechnung um ein dem Fachmann geläufiges Verfahren handelt.

Die Berechnung der Kerbspannungen im zu bewertenden Querschnitt kann also über ein FEM-Modell erfolgen, welches nach den allgemeinen Grundsätzen der FEM-Berechnung unter Einbeziehung der Anforderungen des Kerbspannungskonzepts, meist computergeneriert, erzeugt wird. Ein Nachteil des Stands der Technik äußert sich nun darin, dass für jede unterschiedliche Kombination der geometrischen Parameter, also für jede unterschiedliche Querschnittsgeometrie, das gesamte Berechnungsverfahren wiederholt werden muss: Es muss eine eigenständiges Modell gebildet werden, die Randbedingungen müssen definiert werden und die Berechnung der Kerbspannung am Modell muss für einen speziellen Lastfall durchgeführt werden. Müssen also Kerbspannungen unterschiedlicher zu bewertender Querschnitte eines Bauteils oder geometrisch unterschiedlicher zu bewertender Querschnitte mehrerer Bauteile vielleicht sogar für eine Vielzahl unterschiedlicher Lastfälle berechnet werden, ist ein nur schwer automatisierbarer Prozess notwendig, der rechenintensiv, fehleranfällig und mit hohen Kosten verbunden ist. Desto größer die Zahl der unterschiedlichen Modelle und der unterschiedlichen Berechnungsergebnisse für unterschiedliche Lastfälle, desto schwieriger wird es auch die Menge an Daten zu verwalten. Die Grenzen der technischen Machbarkeit sind dabei schnell erreicht.

### Aufgabe der Erfindung

Es ist daher eine Aufgabe der Erfindung die Nachteile des Stands der Technik zu überwinden und ein computergestütztes Verfahren zur Berechnung von Kerbspannungen an einem zu bewertenden Querschnitt eines zumindest eine Schweißnaht aufweisenden Bauteils vorzuschlagen, welches die Berechnung von Kerbspannungen für eine Vielzahl von zu bewertenden Querschnitten bzw. für einen zu bewertenden Querschnitt einer Vielzahl von Bauteilen bei verringertem Rechenaufwand und verringerter Fehleranfälligkeit ermöglicht.

### Darstellung der Erfindung

Diese Aufgabe wird durch ein computergestütztes Verfahren zur Berechnung von Kerbspannungen mit den Merkmalen des Patentanspruchs 1 gelöst. Vorteilhafte Ausgestaltungen der Erfindung sind in den jeweiligen abhängigen Ansprüchen definiert.

Erfindungsgemäß ist dabei vorgesehen, dass ein Meta-Modell erstellt wird, welches die Berechnung von Kerbspannungs-Informationen erlaubt, mittels derer die Kerbspannungen an einem zu bewertenden Querschnitt berechnet werden können bzw. die die Kerbspannungen an einem zu bewertenden Querschnitt bereits enthalten. Vereinfacht gesagt basiert die Erstellung des Meta-Modells auf zwei Schritten: Im ersten Schritt erfolgt die Berechnung von Kerbspannungs-Informationen für einzelne, diskrete zu bewertende Querschnitte, die jeweils durch eine Kombination aus einer Anzahl N an den zu bewertenden Querschnitt charakterisierenden geometrischen Parametern definiert sind. Im zweiten Schritt wird dann das Meta-Modell als N-dimensionale Funktion erstellt, für welche die berechneten Kerbspannungs-Informationen als Stützstellen fungieren.

Da das Meta-Modell eine Funktion darstellt, deren Definitionsbereich den gesamten Parameterraum der variablen Parameter umfasst, ist es möglich für eine beliebige Kombination der geometrischen Parameter Kerbspannungs-Informationen aus dem Meta-Modell abzuleiten, da dieses die Kerbspannungs-Informationen als Funktionswert der geometrischen Parameter als Eingangsparameter ausgibt.

Die Vorteile des erfindungsgemäß erstellten Meta-Modells liegen dabei auf der Hand: Für die Erstellung des Meta-Modells ist nur die Berechnung einer diskreten Anzahl an Stützstellen notwendig. Sobald das Meta-Modell erstellt ist, kann für einen beliebigen zu bewertenden Querschnitt mit einer spezifischen Kombination der geometrischen Parameter die Kerbspannungs-Information über das Meta-Modell ausgegeben werden ohne dass eine komplexe Berechnung notwendig ist. Es ist also nicht mehr notwendig für die Berechnung unterschiedlicher Querschnittsgeometrien für jede Kombination an geometrischen Parametern eine separate, vollständige Berechnung durchzuführen.

In der Folge soll auf die einzelnen Schritte im Detail eingegangen werden:
Entscheidend für den Umfang des Meta-Modells sind maßgeblich zwei Faktoren verantwortlich: Einerseits die Anzahl der geometrischen Parameter, welche die Dimension des Meta-Modells festlegt, und andererseits die Festlegung der Minimal- und Maximalwerte der einzelnen Parameter. Bei den geometrischen Parametern kann es sich beispielsweise bei einem zu bewertenden Querschnitt mit T-Profil um die Dicke des Stegblechs P₁, die Dicke des Gurtblechs P₂ und den Winkel P₃, den die beiden Bleche miteinander einschließen, handeln. In diesem Fall wäre die Anzahl N der geometrischen Parameter gleich 3. Das auf diesen geometrischen Parametern basierende Meta-Modell, welches als eine Funktion ausgebildet ist, wäre in diesem Fall dreidimensional. Es versteht sich von selbst, dass mit zunehmender Komplexität des zu bewertenden Querschnitts die Anzahl der zur Definition des zu bewertenden Querschnitts notwendigen Parameter ansteigt.

Aus der Anzahl der unterschiedlichen geometrischen Parameter ergibt sich auch die Dimension eines Parameterraums in dem nachfolgend die Stützstellen für das Meta-Modell berechnet werden. Die Grenzen des Parameterraums werden über jeweils einen Minimal- und einen Maximalwert für jeden der geometrischen Parameter festgelegt. Mit anderen Worten begrenzen die jeweiligen Minimal- und Maximalwerte die Ausdehnung des Parameterraums in jeweils einer Dimension. Anhand des zuvor ausgeführten Beispiels könnte hier die Dicke des Stegblechs P₁ mit zwischen 5 mm und 25 mm liegend, die Dicke des Gurtblechs P₂ mit zwischen 10 mm und 30 mm liegend und der Winkel P₃ mit zwischen 60° und 120° liegend eingeschränkt sein.

Innerhalb des Parameterraums werden dann Querschnitts-Modelle, auch Designs genannt, generiert, wobei jedes Querschnitts-Modell durch eine spezifische Kombination an Werten der geometrischen Parametern charakterisiert ist und einen Punkt im Parameterraum darstellt. Ein Querschnitts-Modell hat somit eine spezifische Geometrie, die von den Werten der geometrischen Parameter bestimmt wird. Beispielsweise könnte ein Querschnitts-Modell im zuvor erläuterten Beispiel durch eine Dicke des Stegblechs P₁ von 15 mm, eine Dicke des Gurtblechs P₂ von 20 mm und einen Winkel P₃ von 90° charakterisiert sein. Um das Kerbspannungskonzept der Berechnung der Kerbspannungsinformationen zugrunde legen zu können, werden die lokalen Kerben der Schweißnaht im zu bewertenden Querschnitt durch einen normierten, nach dem Kerbspannungskonzept ausgewählten Kerb-Radius ersetzt. Bei den lokalen Kerben kann es sich sowohl um Übergangskerben als auch um Wurzelkerben handeln.

Für jedes Querschnitts-Modell, das vorzugsweise zumindest zwei Schnittufer aufweist und an den beiden Schnittufern über Schnittlasten belastet ist, werden die Kerbspannungs-Informationen berechnet, aus denen sich in weiterer Folge die tatsächliche Kerbspannung berechnen lässt. Die Kerbspannungs-Informationen stellen einen Funktionswert des durch die Werte der geometrischen Parameter festgelegten Punkts im Parameterraum dar. Diese Berechnung kann beispielsweise mittels herkömmlicher FEM-Berechnungen erfolgen oder aber mittels der Inertia-Relief-Methode, wie später ausführlich erläutert wird.

Dadurch, dass eine diskrete Anzahl an Querschnitts-Modellen erstellt wird, die jeweils einen Punkt im Parameterraum darstellen, und dass die Kerbspannungs-Informationen für jede Stützstelle als Funktionswert der Stützstelle berechnet werden, resultiert eine diskrete Anzahl an Stützstellen und den Stützstellen zugeordneten Funktionswerten.

Das Meta-Modell wird basierend auf den Stützstellen und den Funktionswerten der Stützstellen als N-dimensionale Funktion berechnet, indem die Funktionswerte des Meta-Modells an die Funktionswerte der Stützstellen angenähert werden. Dabei werden an sich aus der DoE, Design of Experiment, Methode bekannte Algorithmen eingesetzt, deren Ergebnis beispielsweise mittels einer Sensitivitätsanalyse auf ihre Plausibilität überprüft wird. Bevorzugt handelt es sich bei der Funktion um eine stetige Funktion, die über den gesamten Parameterraum Ergebnisse liefert.

Mit dem erfindungsgemäß erstellten Meta-Modell ist es nun möglich, für eine beliebige Kombination der Werte der geometrischen Parameter die entsprechenden Kerbspannungs-Informationen zu berechnen. In anderen Worten ist das Meta-Modell nicht mehr abhängig von den diskreten Stützstellen, die wie zuvor beschrieben erstellt und berechnet werden müssen, sondern es ist möglich, im gesamten Parameterraum für beliebige Punkte, die durch die Werte für die geometrischen Parameter jeweils einen spezifischen zu bewertenden Querschnitt darstellen, die resultierenden Kerbspannungs-Informationen zu erhalten. Dazu ist es lediglich notwendig, die Werte der geometrischen Parameter als Argumente an das Meta-Modell zu übergeben und mittels des Meta-Modells die entsprechenden Kerbspannungs-Informationen zu berechnen. Das Erstellen von Querschnitts-Modellen und die komplizierte Berechnung der Kerbspannungs-Informationen im Querschnitts-Modell sind damit hinfällig.

Um eine möglichst große Anzahl an geometrisch unterschiedlichen zu bewertenden Querschnitten abbilden zu können, ist in einer Ausführungsvariante der Erfindung vorgesehen, dass die geometrischen Parameter zumindest eine, vorzugsweise eine Kombination mehrerer, der nachfolgenden Informationen umfasst: Abmessungen der einzelnen den zu bewertenden Querschnitt bildenden Komponenten des Bauteils, relative Position der Komponenten zueinander, geometrische Parameter des Querschnitts der Schweißnaht. Ein Meta-Modell ist in der Regel auf einen bestimmten Grund-Querschnitt beschränkt, also beispielsweise auf zwei Bleche, die mittels zweier Kehlnahten in einem Winkelbereich von zwischen 60° und 120° liegen. Über die Festlegung des Parameterbereichs wird sodann genauer definiert, in welchem zahlenmäßigen Bereich das Meta-Modell geeignet sein soll, die Kerbspannungs-Informationen zu generieren.

Da eine diskrete Anzahl an Stützstellen, also an Querschnitts-Modellen, benötigt wird, um die N-dimensionale Funktion, also das Meta-Modell, berechnen zu können, ist es notwendig im durch Minimal- und Maximalwert festgelegten Parameterraum Zwischenwerte zu definieren. Durch die Kombination der Zwischenwerte untereinander, werden somit alle Stützstellen im N-dimensionalen Parameterraum definiert. Es ist dabei notwendig, die Anzahl der Stützstellen, so gering wie möglich, jedoch gleichzeitig so groß wie nötig zu halten, um eine möglichst genaue Berechnung der Funktionswerte des Meta-Modells zu erhalten, dabei jedoch den Berechnungsaufwand, der für jedes Querschnitts-Modell erheblich ist, in vertretbaren Grenzen zu halten. Daher sieht eine weitere Ausführungsvariante der Erfindung vor, dass im Parameterraum Zwischenwerte zwischen dem Minimalwert und dem Maximalwert der geometrischen Parameter derart verteilt werden, dass genügend Querschnitts-Modelle als Stützstellen zur Erstellung des als N-dimensionale Funktion ausgebildeten Meta-Modells zur Verfügung stehen.

Um die Abweichung der Funktionswerte des Meta-Modells von den Funktionswerten der Stützstellen so gering wie möglich zu halten und gleichzeitig die zwischen den Stützstellen befindlichen Bereiche des Parameterraums besonders gut annähern zu können, ist gemäß einer weiteren Ausführungsvariante des Verfahrens vorgesehen, dass die Annäherung der Funktionswerte des Meta-Modells an die Funktionswerte der Stützstellen mittels eines iterativen Optimierungsverfahrens erfolgt.

In einer weiteren Ausführungsvariante der Erfindung ist vorgesehen, dass die Querschnitts-Modelle als FEM-, Finite Elemente Methoden, Modelle erstellt werden. Ein derartiges Querschnitts-Modell kann beispielsweise über ein CAD, Computer Aided Design, Programm erstellt werden und etwa dreidimensional oder zweidimensional ausgebildet sein. Durch die Verwendung von FEM-Modellen, ist es möglich, die Querschnitts-Modelle mit handelsüblichen Programmen zu erstellen und Berechnungen daran vorzunehmen. Besonders gut eignen sich beispielsweise aus den CAD-Modellen abgeleitete FEM-Modelle, in dem der zu bewertende Querschnitt mittels eines Netzes aus miteinander verbundenen Knotenpunkten abgebildet ist. Durch die Verschiebung der Knotenpunkte unter Berücksichtigung einer Steifigkeitsmatrix können so in einfacher Art und Weise die Einheits-Teil-Kerbspannungen berechnet werden.

Eine bevorzugte Ausführungsvariante der Erfindung sieht vor, dass als Kerbspannungs-Informationen für jedes Querschnitts-Modell Einheits-Teil-Kerbspannungen für definierte Einheitslasten, vorzugsweise mittels der Inertia-Relief Methode, berechnet werden. Spannungen in den Querschnitts-Modellen resultieren immer aus der Belastung der Querschnitts-Modelle. Würde man nun für jeden konkreten Lastfall, also eine Kombination von Kräften und Momenten, die Kerbspannungs-Informationen berechnen, so müsste für jeden unterschiedlichen Lastfall ein eigenes Meta-Modell erstellt werden. Eine solche Vorgehensweise ist zwar denkbar, aber unwirtschaftlich. Trotzdem sieht eine alternative Ausführungsvariante der Erfindung vor, dass als Kerbspannungs-Informationen für jedes Querschnitts-Modell die aus einer an den Querschnitts-Modellen angreifenden Last resultierenden Kerbspannungen berechnet werden.

Werden für jedes Querschnitts-Modell aber nicht die Kerbspannungs-Informationen für einen konkreten Lastfall berechnet, sondern die Kerbspannungs-Informationen für die Belastung des Querschnitts-Modells mit zumindest einer normierten Einheitslast, so lassen sich die Kerbspanungs-Informationen für eine Vielzahl von Lastfällen universell einsetzen. Für komplexe Belastungen sind mehr als eine Einheitslast notwendig. Bei dieser Einheitslast kann es sich sowohl um eine Kraft als auch um ein Moment handeln, wobei der Betrag der Einheitslast vorzugsweise einer ganzzahligen Potenz der Basiszahl zehn entspricht. Es versteht sich jedoch von selbst, dass der Betrag der Einheitslast beliebig groß gewählt sein kann. Nachfolgend ein Beispiel an Hand der Inertia-Relief Methode:
Das Querschnitts-Modell wird mit der ersten Einheitslast belastet und mittels der Inertia-Relief Methode die Systemantwort des zu bewertenden Querschnitts auf die erste Einheitslast in Form eines ersten Beschleunigungsfelds bestimmt. In einfachen Worten ausgedrückt wird dabei der zu bewertende Querschnitt nicht wie bei einem herkömmlichen FEM-Berechnungsverfahren "festgehalten", sodass die Verschiebungen der einzelnen Knotenpunkte bestimmt werden können, sondern es wird ein Beschleunigungsfeld berechnet, mit dem der zu bewertende Querschnitt des Querschnitts-Modells beaufschlagt wird, sodass die aus der Beschleunigung resultierende Kraft (die sich nach der Newton'schen Beziehung als Kraft gleich Masse mal Beschleunigung ergibt) mit der ersten Einheitslast im Gleichgewicht steht. Der zu bewertende Querschnitt steht also nicht im statischen oder quasi statischen Gleichgewicht, sondern wird einer ununterbrochenen Beschleunigung unterzogen. Mittels der Inertia-Relief Methode lassen sich aus dem dynamischen Gleichgewichts-Zustand des ersten Beschleunigungsfeldes und der Einheitslast Spannungen im zu bewertenden Querschnitt berechnen. Dementsprechend lässt sich auch die, aus der Belastung des zu bewertenden Querschnitts mit der Einheitslast resultierende, Kerbspannung als Teil der Kerbspannungs-Informationen berechnen. Diese Kerbspannung kann mittels der Inertia-Relief Methode exakt und analytisch bestimmt werden, sodass der Kraftfluss aufgrund der ersten Einheitslast durch den zu bewertenden Querschnitt des Querschnitts-Modells, ohne etwaige Annahmen treffen zu müssen, dem tatsächlich durch die Einheitslast bedingten Kraftfluss-Komponente entspricht. Wiederholt man die Berechnung mit allen Einheitslasten, so kann man mittels der Kerbspannungs-Informationen, die die einzelnen, aus den jeweiligen Einheitslasten resultierenden Spannungen enthalten, mittels des Superpositionsprinzips die tatsächlichen Spannungen im Querschnitts-Modell aufgrund eines konkreten Lastfalls berechnen.

Um nun mithilfe des Meta-Modells Kerbspannungs-Informationen für beliebige Punkte des Parameterraums berechnen zu können, die unabhängig von der tatsächlichen Belastung des zu bewertenden Querschnitts sind und für die Berechnung einer Vielzahl an Lastfällen verwendet werden können, ist in einer weiteren bevorzugten Ausführungsvariante der Erfindung vorgesehen, dass die Einheitslasten als linear unabhängige Einheitskräfte und/oder Einheitsmomente ausgebildet sind, sodass sich beliebige Lastzustände am zu bewertenden Querschnitt eines Bauteils als Linearkombination der Einheitslasten darstellen lassen. Für eine solche Darstellbarkeit ist es notwendig, das die Einheitskräfte und die Einheitsmomente ein Koordinatensystem aufspannen mittels welchem jede auf den zu bewertenden Querschnitt wirkende Last in einzelne Komponenten in den Richtungen des durch die Einheitslasten definierten Koordinatensystems aufgeteilt werden kann. Vorzugsweise sind für jedes Schnittufer ein eigenes Koordinatensystem und dieses aufspannende Einheitslasten vorgesehen. Dadurch, dass die Einheitskräfte und/oder die Einheitsmomente linear unabhängig voneinander sind, wird erreicht, dass sich jede Kraft bzw. jedes Moment durch eine Linearkombination der Einheitslasten darstellen lässt. Für einen allgemeinen zweidimensionalen Belastungszustand sind dafür zwei Einheitskräfte und ein Einheitsmoment notwendig, für einen allgemeinen dreidimensionalen Belastungszustand drei Einheitskräfte und drei Einheitsmomente. Besonders bevorzugt spannen die Einheitskräfte und/oder die Einheitsmomente ein orthogonales Koordinatensystem auf, um die Berechnung der Kerbspannungs-Informationen zu vereinfachen.

Gemäß einer besonders bevorzugten Ausführungsvariante des erfindungsgemäßen Verfahrens, wird das Meta-Modell als N-dimensionale nicht lineare rationale Basis-Splines abgebildet. Diese werden auch als NURBS, non-uniform rational B-Splines, bezeichnet. NURBS werden etwa im Computergrafik-Bereich, beispielsweise im CGI oder CAD, zur Modellierung beliebiger Formen verwendet. Ein NURBS kann jeden beliebigen nicht-verzweigenden stetigen Verlauf einer Kurve oder Fläche darstellen. Eine N-dimensionale Fläche wird dabei durch wenige sogenannte Kontrollpunkte definiert, wobei durch die B-Splines die einzelnen Kontrollpunkte unterschiedlich stark (non uniform) auf den Verlauf der Fläche einwirken können.

In einer weiteren bevorzugten Ausführungsvariante des erfindungsgemäßen Berechnungsverfahrens ist vorgesehen, dass das Meta-Modell nach der Erstellung in einem nicht temporären Speicher gespeichert wird. Somit kann sichergestellt werden, dass das Meta-Modell nicht nach Beendigung der Berechnung gelöscht wird bzw. für weitere Berechnungen wiederverwendbar ist.

Um nun mit dem mittels des erfindungsgemäßen Verfahrens erstellten Meta-Modell die Kerbspannung im zu bewertenden Querschnitt eines Bauteils berechnen zu können, wird ein Verfahren zur Ermittlung von Kerbspannungen für einen zu bewertenden Querschnitt eines zumindest eine Schweißnaht mit einer Kerbe aufweisenden Bauteils mit einem erfindungsgemäßen Meta-Modell vorgeschlagen, wobei der zu bewertende Querschnitt des Bauteils durch eine spezifische Kombination an geometrischen Parametern und deren konkrete Werte definiert ist und durch eine definierte Last belastet ist, wobei folgende Verfahrensschritte durchgeführt werden:
- Übergeben der Werte der geometrischen Parameter als Argumente an das Meta-Modell;
- Berechnen der Kerbspannungs-Informationen des zu bewertende Querschnitts mittels des Meta-Modells als Funktionswert der übergebenen Werte der geometrischen Parametern;
- Berechnen der Kerbspannungen des zu bewertenden Querschnitts des Bauteils aus den Kerbspannungs-Informationen.

Mit diesem Verfahren wird nun die konkrete Berechnung einer Kerbspannung für einen definierten zu bewertenden Querschnitt ermöglicht, indem die Werte der geometrischen Parameter des zu bewertenden Querschnitts an ein erfindungsgemäß erstelltes Meta-Modell als Eingangsgrößen übergeben werden und aus dem als N-dimensionale Funktion ausgebildeten Meta-Modell die Kerbspannungs-Informationen für den zu bewertenden Querschnitt berechnet. Da die an das Meta-Modell übergebenen Argumente einen Punkt im Parameterraum darstellen und über das Meta-Modell für jeden Punkt die Kerbspannungs-Informationen als Funktionswert des Meta-Modells berechnet werden können, ist keine gesonderte Spannungsberechnung mehr an einem Modell notwendig.

Die Berechnung der Kerbspannungen selbst kann im Wesentlichen nach zwei unterschiedlichen Verfahren erfolgen, wobei auch Kombinationen der beiden Verfahren bzw. alternative Verfahren denkbar sind.

In der ersten Variante ist das Meta-Modell genau für die definierte Last, die auf den zu bewertenden Querschnitt wirkt, berechnet. Mit anderen Worten wurden alle Querschnitts-Modelle mit der definierten Last belastet, sodass die Kerbspannungs-Informationen bereits die Kerbspannungen aufgrund der definierten Last enthalten und somit auch die aus dem Meta-Modell generierten Kerbspannungs-Informationen auf den spezifischen Lastfall zugeschnitten sind. Diese Variante kann sinnvoll sein, wenn eine Vielzahl an unterschiedlichen zu bewertenden Querschnitten unter demselben Lastfall analysiert werden müssen.

Eine weitere Ausführungsvariante des Verfahrens, die der zweiten Variante entspricht, sieht vor, dass die Kerbspannungs-Informationen in Form eines aus dem Meta-Modell abgeleiteten, die Einheits-Teil-Kerbspannungen und die den Einheits-Teil-Kerbspannungen zugrunde liegenden Einheitslasten enthaltenden, Sub-Modells ausgegeben werden, wobei mittels der Einheits-Teil-Kerbspannungen die Kerbspannungen des Bauteils für beliebige Lastzustände berechnet werden können.

Die Verwendung von Sub-Modellen, welche unabhängig von der tatsächlich auf den zu bewertenden Querschnitt wirkenden Last gelten, ist nur dann möglich, wenn bereits bei der Erstellung des Meta-Modells für jedes Querschnitts-Modell die lastunabhängigen Kerbspannungs-Informationen, vorzugsweise mittels der Inertia-Relief Methode, berechnet wurden. In der Folge wird die Erstellung eines Sub-Modells für ein Querschnitts-Modell an Hand der Inertia-Relief Methode erläutert. Dieses Sub-Modell lässt sich durch das Meta-Modell für jeden beliebigen Punkt des Parameterraums erstellen, ohne eben die Erstellung des Sub-Modells abhängig von den Werten der geometrischen Parameter durchführen zu müssen.

Anstatt der tatsächlichen Last wird zumindest eine normierte Einheitslast der Erstellung des Sub-Modells zu Grunde gelegt. Bei dieser Einheitslast kann es sich sowohl um eine Kraft als auch um ein Moment handeln, wobei der Betrag der Einheitslast vorzugsweise einer ganzzahligen Potenz der Basiszahl Zehn entspricht. Es versteht sich jedoch von selbst, dass der Betrag der Einheitslast beliebig groß gewählt sein kann, wie nachfolgend erläutert.

Zur Erstellung des Sub-Modells wird nun der zu bewertende Querschnitt mit der ersten Einheitslast belastet und mittels der Inertia-Relief Methode die Systemantwort des zu bewertenden Querschnitts auf die erste Einheitslast in Form des ersten Beschleunigungsfelds bestimmt. In einfachen Worten ausgedrückt wird dabei der zu bewertende Querschnitt nicht wie bei einem herkömmlichen FEM-Berechnungsverfahren "festgehalten", sodass die Verschiebungen der einzelnen Knotenpunkte bestimmt werden können, sondern es wird ein Beschleunigungsfeld berechnet, mit dem der zu bewertende Querschnitt beaufschlagt wird, sodass die aus der Beschleunigung resultierende Kraft (die sich nach der Newton'schen Beziehung als Kraft gleich Masse mal Beschleunigung ergibt) mit der ersten Einheitslast im Gleichgewicht steht. Der zu bewertende Querschnitt steht also nicht im statischen oder quasi statischen Gleichgewicht, sondern wird einer ununterbrochenen Beschleunigung unterzogen. Mittels der Inertia-Relief Methode lassen sich aus dem dynamischen Gleichgewichts-Zustand des ersten Beschleunigungsfeldes und der Einheitslast Spannungen im zu bewertenden Querschnitt berechnen. Dementsprechend lässt sich auch die, aus der Belastung des zu bewertenden Querschnitts mit der Einheitslast resultierende, Kerbspannung berechnen, die in der Folge als Einheits-Teil-Kerbspannung aufgrund der ersten Einheitslast, oder in mathematischer Weise dargestellt σ_{TE}(E₁), bezeichnet wird. Diese erste Einheits-Teil-Kerbspannung σ_{TE}(E₁) kann mittels der Inertia-Relief Methode exakt und analytisch bestimmt werden, sodass der Kraftfluss aufgrund der ersten Einheitslast durch den zu bewertenden Querschnitt, ohne etwaige Annahmen treffen zu müssen, dem tatsächlich durch die Einheitslast bedingten Kraftfluss-Komponente entspricht.

Umfasst das Sub-Modell nur eine normierte Einheitslast, so ist die Erstellung bereits abgeschlossen. In der praktischen Anwendung sind mehrere verschieden gerichtete und/oder verschieden geartete Einheitslasten erforderlich, um einen allgemeinen Belastungszustand darzustellen, daher wird der zuvor beschriebene Berechnungsvorgang für jede weitere normierte Einheitslast wiederholt, wobei jeweils immer nur die Systemantwort auf eine einzige Einheitslast berechnet wird. Wie bereits zuvor erwähnt, ist es vorteilhaft, wenn die Einheitskräfte als linear unabhängige Einheitskräfte und Einheitsmomente, vorzugsweise für jedes Schnittufer des Querschnitts-Modells, ausgebildet sind. Am Ende der Berechnung steht immer eine Einheits-Teil-Kerbspannung aufgrund einer bestimmten Einheitslast oder in mathematischer Weise dargestellt σ_{TE}(E_{X}). Dabei steht der Index "X" für eine spezielle Einheitslast, die aus der Gruppe der Einheitslasten ausgewählt ist. Der Wert für den Index "X" liegt dabei also zwischen 1, für die erste Einheitslast, und n, für die letzte Einheitslast. Diese Nomenklatur wir in der Folge auch im Zusammenhang mit den Kerbspannungen weiterverwendet.

Dieser Vorgang wird für alle Einheitslasten wiederholt, wobei der Index "X" sich schrittweise für jeden Berechnungsdurchgang erhöht, bis für alle Einheitslasten E₁,...,Eₙ die entsprechenden Einheits-Teil-Kerbspannungen σ_{TE}(E₁),...,σ_{TE}(Eₙ) berechnet sind. Sobald alle Einheits-Teil-Kerbspannungen berechnet sind, ist das Sub-Modell, welches alle Einheits-Teil-Kerbspannungen umfasst, erstellt.

Wie zuvor erläutert, ist es durch die Erstellung des Meta-Modells möglich, diese komplexen Berechnungen zur Erstellung eines Sub-Modells nur für die diskrete Anzahl an Querschnitts-Modellen, die die Stützstellen für die N-dimensionale Funktion bilden, durchzuführen, und dann mittels des Meta-Modells Sub-Modelle für einen beliebigen zu bewertenden Querschnitt zu erstellen. Mittels des Sub-Modells als Kerbspannungs-Information ist eine Berechnung der Kerbspannungen unabhängig von der tatsächlich auf den zu bewertenden Querschnitt wirkenden definierten Last möglich. Wird also ein Sub-Modell für einen zu bewertenden Querschnitt aus dem Meta-Modell generiert, so kann damit die Kerbspannung für einen beliebigen Lastfall berechnet werden. Die unterschiedlichen Lastfälle können sich dabei in der Anzahl, der Richtung, der Art (Kraft oder Moment) und dem Betrag der Last unterscheiden.

Die Berechnung der Kerbspannung an einem definierten zu bewertenden Querschnitt, für den ein Sub-Modell aus dem Meta-Modell abgeleitet wurde, für eine definierte auf den zu bewertenden Querschnitt wirkende Kraft erfolgt gemäß einer weiteren bevorzugten Ausführungsvariante der Erfindung, indem folgende Schritte durchgeführt werden:
- Bestimmen von Linearkombinations-Faktoren für den zu berechnenden Lastzustand, wobei die den Kerbspannungen zugrunde liegenden Schnittlasten als Linearkombination der Einheitslasten dargestellt werden;
- Multiplizieren der Linearkombinations-Faktoren mit den jeweils der entsprechenden Einheitslast zugeordneten Einheits-Teil-Kerbspannungen;
- Superposition der einzelnen Produkte von Einheits-Teil-Kerbspannungen und Linearkombinations-Faktoren.

Auf der Grundlage des Sub-Modells kann nachfolgend die tatsächliche Kerbspannung σ_{K}, die tatsächlich durch die definierte auf den zu bewertenden Querschnitt wirkende Last hervorgerufen wird, in erfindungsgemäßer Art und Weise schnell und wirtschaftlich berechnet werden. Das Berechnungsverfahren umfasst dabei die folgenden Schritte:
Um die berechneten Einheits-Teil-Kerbspannungen σ_{TE}(E₁),...,σ_{TE}(Eₙ) aus dem Submodell verwenden zu können, wird der durch die Last in dem zu bewertenden Querschnitt vorherrschende Belastungszustand, also in anderen Worten die am zu bewertenden Querschnitt angreifenden Kräfte und/oder Momente, als Linearkombination der Einheitslasten dargestellt. So lässt sich in einem zweidimensionalen Modell eine allgemeine am zu bewertenden Querschnitt angreifende Last als Linearkombination von drei normierten Einheitslasten, insbesondere je Schnittufer, darstellen, wobei die drei Einheitslasten jeweils 2 Kräfte und 1 Biegemoment umfassen. Durch die entsprechende Berechnung von Linearkombinations-Faktoren für jede Einheitslast, lässt sich der Belastungszustand als Linearkombination der Einheitslasten darstellen, sodass die Summe der Produkte jeweils eines berechneten Linearkombinations-Faktors mit einer Einheitslast für alle Einheitslasten dem tatsächlichen Belastungszustand entspricht. Anhand eines einfachen Beispiels erklärt, berechnet sich für einen zu bewertenden Querschnitt mit einer als Einheitskraft ausgebildeten Einheitslast mit dem Betrag 0,5 N und einer in derselben Wirklinie zur Einheitskraft wirkenden als Schnittkraft ausgebildeten Last von 8 N ein Linearkombinations-Faktor n₁ von 8 N/0,5 N gleich 16. In analoger Art und Weise lassen sich entsprechend auch Lasten im zweidimensionalen und dreidimensionalen Raum aufteilen.

Sobald die Linearkombinations-Faktoren für den gesamten Belastungszustand bestimmt sind, werden auf Basis der im Sub-Modell vorhandenen Einheits-Teil-Kerbspannungen aufgrund der Einheitslast σ_{TE}(E₁),...,σ_{TE}(Eₙ) Teil-Kerbspannungen, oder in mathematischer Weise ausgedrückt σ_{T}, berechnet, indem die Linearkombinations-Faktoren mit der Einheits-Teil-Kerbspannung der dem Linearkombinations-Faktor zugehörigen Einheitslast multipliziert werden. Anhand des zuvor genannten Beispiels erläutert, berechnet sich die Teil-Kerbspannung σ_{T1} aus der Multiplikation des Linearkombinations-Faktors n₁ mit der Einheits-Teil-Kerbspannung σ_{TE}(E₁). Dieses Verfahren wird so oft wiederholt, bis alle bestimmten Linearkombinations-Faktoren in Teil-Kerbspannungen umgerechnet sind.

Es versteht sich dabei von selbst, dass es mathematisch gesehen keinen Unterschied macht, ob zuerst alle Linearkombinations-Faktoren bestimmt werden und danach alle Teil-Kerbspannungen berechnet werden oder ob für jeden Linearkombinations-Faktor oder für einzelne durch Linearkombinations-Faktoren dargestellte unterschiedliche Kräfte und/oder Momente des Belastungszustands unmittelbar die entsprechenden Teil-Kerbspannungen berechnet werden. Gleichermaßen können auch die Linearkombinations-Faktoren für eine Einheitslast die Komponenten verschiedener Kräfte und/oder verschiedener Momente enthält in einem kombinierten Linearkombinations-Faktor zusammengefasst werden.

Um das Endergebnis der Berechnung, also die Kerbspannungen in dem zu bewertenden Querschnitt aufgrund der auf den Querschnitt wirkenden Belastung zu erhalten, werden im letzten Schritt des Verfahrens die einzelnen Teil-Kerbspannungen mittels linearer Superposition addiert. Es soll in diesem Zusammenhang nicht unerwähnt bleiben, dass die Einheits-Teil-Kerbspannungen für sich genommen keine Aussagekraft über die tatsächlich vorliegende Kerbspannung im Lastfall haben. Erst durch die Superposition der Teil-Kerbspannungen wird der Einfluss der den Belastungszustand definierenden Last auf den zu bewertenden Querschnitt tatsächlich dargestellt. Mit anderen Worten wird der tatsächlich im zu bewertenden Querschnitt vorliegende Kraftfluss erst dann durch das Berechnungsergebnis widergespiegelt, wenn die gesamte definierte Last durch die Superposition der Teil-Kerbspannungen berücksichtigt ist. Im Falle einer quasistatischen Belastungs-Situation stehen die die definierte Last ausbildenden Kräfte und/oder Momente im Gleichgewicht. Für den Fall, dass die definierte Last auch Beschleunigungen beinhaltet, stehen die übrigen Kräfte und/oder Momente der Last mit den Beschleunigungen im Gleichgewicht (dynamisches Gleichgewicht: Kraft gleich Masse mal Beschleunigung).

Unter dem Begriff Einheits-Teil-Kerbspannung ist nicht zwangsläufig ein einzelner Wert zu verstehen, sondern ist auch ein Vektor, ein Tensor oder eine, vorzugsweise mehrdimensionale, Matrix, vorzugsweise mit einem Tensor oder einem Vektor für einen oder mehrere Knotenpunkte eines Gitternetzes, zu verstehen. Analoges gilt natürlich auch für die Teil-Kerbspannungen und die Kerbspannung selbst. Umfasst der zu bewertende Querschnitt zwei, drei oder mehr Schweißnähte, so können auch Einheits-Teil-Kerbspannung, Teil-Kerbspannung und Kerbspannung entsprechende Werte, Vektoren, Tensoren oder Matrizen für jede erforderlichen Stelle der Schweißnähte umfassen, an denen später eine Bewertung der Kerbspannung durchgeführt werden soll. Insbesondere ist in der Kerbspannung ein Spannungstensor für zumindest einen im Kerb-Radius einer Schweißnaht enthaltenen Knotenpunkt enthalten. Vorzugsweise ist eine Vielzahl, besonders bevorzugt alle, den Kerb-Radius ausbildenden Knotenpunkte jeder Schweißnaht von der berechneten Kerbspannung umfasst.

Die Vorteile dieses Verfahrens stellen sich dabei wie folgt dar: Da die Einheits-Teil-Kerbspannungen mittels der Inertia-Relief Methode berechnet werden und den jeweils durch eine der Einheitslasten bewirkten Kraftfluss durch den zu bewertenden Querschnitt repräsentieren, spiegelt die Superposition der Linearkombinationen der Teil-Kerbspannungen den tatsächlichen, durch die definierte Last bewirkten Kraftfluss durch den zu bewertenden Querschnitt wieder. Bei keiner der Berechnungen ist es notwendig eine Annahme über die Randbedingungen treffen zu müssen, sodass die berechnete Kerbspannung keinerlei durch eine Annahme bedingte Fehler aufweist. Mit anderen Worten handelt es sich bei dem Ergebnis des erfindungsgemäßen Berechnungsverfahrens um eine analytisch exakte Lösung des mechanischen Problems.

Ein weiterer Vorteil liegt in der Erstellung des Sub-Modells: Dadurch, dass das Sub-Modell auf Basis der Einheitslasten erstellt wird und damit die tatsächlich auf den zu bewertenden Querschnitt wirkende Last, weder nach Art, Richtung oder Betrag in die Erstellung des Sub-Modells einbezogen ist, können die berechneten Einheits-Teil-Kerbspannungen eines Submodells als Basis für eine Vielzahl an unterschiedlichen Lastfällen mit entsprechenden unterschiedlichen definierten Lasten herangezogen werden. Dabei erfolgt die mathematisch komplexe und rechenintensive Bestimmung der Einheits-Teil-Kerbspannungen nur einmal bei der Erstellung des Sub-Modells. Zur Berechnung der Kerbspannung aufgrund eines tatsächlichen Lastfalles mit einer konkreten definierten Last kann auf die bereits berechneten Einheits-Teil-Kerbspannungen des Sub-Modells zurückgegriffen werden, wobei nur mehr die Linearkombination und die Superposition berechnet werden müssen. Sowohl die Linearkombination als auch die Superposition stellen dabei sehr einfache und wenig komplexe Berechnungsverfahren dar, die wenig Rechenkapazität benötigen und daher schnell und wirtschaftlich abgewickelt werden können. Somit lässt sich nach der Erstellung des Sub-Modells für einen zu bewertenden Querschnitt die Kerbspannung für eine große Anzahl unterschiedlicher Lastfälle mit in Art, Richtung und Betrag verschiedenen definierten Lasten schnell und kostengünstig, in Bezug zu der benötigten Rechenleistung, berechnen.

Um die Sensitivität der durch das Meta-Modell erstellten Kerbspannungs-Informationen zu verbessern und die Abweichungen der mittels des Meta-Modells berechneten Kerbspannungs-Informationen von den tatsächlichen Kerbspannungs-Informationen so gering als möglich zu halten, ist in einer weiteren bevorzugten Ausführungsvariante vorgesehen, dass die an das Meta-Modell übergebenen Werte der geometrischen Parameter innerhalb der Grenzen der definierten Parameterräume des jeweiligen geometrischen Parameters liegen. Es versteht sich dabei von selbst, dass auch die Berechnung für Punkte die außerhalb des Parameterraums liegen denkbar ist, jedoch nimmt die Qualität und Prognosegüte der Kerbspannungs-Informationen mit zunehmendem Abstand der Punkte von den Grenzen des Parameterraums immer weiter ab.

In einer weiteren besonders bevorzugten Ausführungsvariante ist vorgesehen, dass die Kerbspannungs-Informationen und/oder die Kerbspannung eine tangentiale Spannungskomponente für einen am Kerb-Radius angeordneten Knotenpunkt des zu bewertenden Querschnitts aufweist oder dass eine tangentiale Spannungskomponente aus der Kerbspannung berechnet wird, wobei die tangentiale Spannungskomponente tangential zum Kerb-Radius ausgerichtet ist, und dass die tangentiale Spannungskomponente für die Bewertung der Schweißnähte verwendet wird. Für die Bewertung der Kerbspannungen sind die Kerbspannungen in den, den Kerb-Radius ausbildenden Knotenpunkten des zu bewertenden Querschnitts von besonderer Bedeutung. Die tangentiale Spannungskomponente die im Knotenpunkt tangential zum Kerb-Radius steht, wird gemeinhin als "Kerbspannung" bezeichnet. Je nach Ausrichtung des Koordinatensystems kann es daher notwendig sein, dass der Spannungstensor im Knotenpunkt transformiert werden muss, um eine tangentiale Spannungskomponente aufzuweisen. Die tangentiale Spannungskomponente der Kerbspannung kann dann zur Bewertung der Schweißnähte nach dem Kerbspannungskonzept verwendet werden, wobei des Weiteren auch Längs- und Schubspannungen berücksichtigt werden müssen, die über andere Verfahren bestimmt werden.

Eine erfindungsgemäße Aufgabe wird auch durch ein Computerprogrammprodukt (z.B. in Form eines Datenträgers, eines Speichermediums oder eines Signals) gelöst, welches ein Programm umfasst und direkt in einen Speicher eines Rechners ladbar ist, mit Programm-Mitteln, um alle Schritte des erfindungsgemäßen Verfahrens auszuführen, wenn das Programm vom Rechner ausgeführt wird. Die automatisierte Erstellung der Querschnitts-Modelle, die Berechnung der Kerbspannungs-Informationen der Querschnitts-Modelle und die Berechnung des Meta-Modells als N-dimensionale Funktion auf einen oder mehrere, vorzugsweise leistungsstarke, Prozessorkerne auszulagern, ist für die Geschwindigkeit der Berechnung und die Zuverlässigkeit der Ergebnisse von besonderem Vorteil. Auch die Implementierung der Berechnungsschritte zur Berechnung der Kerbspannungs-Informationen als Computerprogramm, welches insbesondere die Berechnung der Einheits-Teil-Kerbspannungen nach der Inertia-Relief Methode beherrscht, ist von großem Vorteil. Wenn das Computerprogramm als Modul eines umfangreicheren Berechnungsprogramms, etwa eines FEM basierten Softwarepakets, ausgeführt ist, um Grundfunktionen, wie die Erstellung des FEM-Modells, des Berechnungsprogramms nützen zu können, ist es möglich, alle relevanten Schritte von der Erstellung der Querschnitts-Modelle über die Berechnung der Kerbspannungs-Informationen für die Querschnitts-Modelle und die Erstellung des Meta-Modells bis hin zur Berechnung der Kerbspannungen eines konkreten zu bewertenden Querschnitts aus einem aus dem Meta-Modell abgeleiteten Sub-Modell aus einer Hand durchzuführen.

Der Vollständigkeit halber sei angemerkt, dass ein Meta-Modell beispielsweise für einen Punkt am Kerb-Radius erstellt sein kann, sodass für die tatsächliche Bewertung der Kerbspannung in einem zu bewertenden Querschnitt mehrere Meta-Modelle für unterschiedliche Punkte am Kerb-Radius einer Schweißnaht benötigt werden. Umfasst der zu bewertende Querschnitt mehrere Schweißnähte, so können für jede Schweißnaht mehrere Meta-Modelle vorgesehen sein, die jeweils unterschiedliche Punkte beschreiben. Theoretisch ist es auch denkbar, mehrere Punkte eines Kerb-Radius oder sogar mehrere Punkte unterschiedlicher Kerb-Radien mit einem Meta-Modell abzudecken, jedoch steigt die erforderliche Rechenleistung zur Erstellung des Meta-Modells und die Komplexität des Meta-Modells selbst in diesen Fällen extrem an.

### Kurzbeschreibung der Figuren

Zur weiteren Erläuterung der Erfindung wird im nachfolgenden Teil der Beschreibung auf die Figuren Bezug genommen, aus der weitere vorteilhafte Ausgestaltungen, Einzelheiten und Weiterbildungen der Erfindung zu entnehmen sind. Die Figuren sind als beispielhaft zu verstehen und sollen den Erfindungscharakter zwar darlegen, ihn aber keinesfalls einengen oder gar abschließend wiedergeben. Es zeigten:
- Fig. 1: eine Ausführungsvariante eines zu bewertenden Querschnitts eines Bauteils;
- Fig. 2: eine Prinzipdarstellung der Inertia-Relief Methode.

### Ausführung der Erfindung

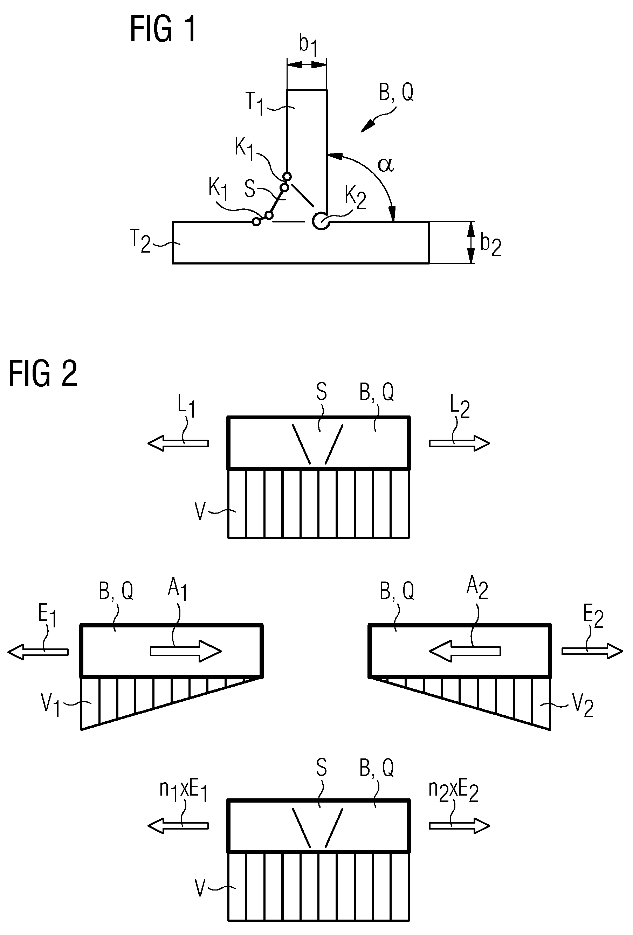

Figur 1 zeigt eine Ausführungsvariante eines zu bewertenden Querschnitts Q eines Bauteils B mit einer Schweißnaht S an dem Kerbspannungen σ_{K} ermittelt werden sollen. Das Bauteil B besteht hier exemplarisch aus zwei Blechen T₁,T₂, nämlich einem in der Abbildung vertikal ausgerichteten Stegblech T₁ und einem in der Abbildung horizontal ausgerichteten Gurtblech T₂, die T-förmig angeordnet sind. Die beiden Bleche T₁,T₂ sind durch eine Schweißnaht S miteinander verbunden. Der dargestellte zu bewertende Querschnitt Q ist normal zur Längs-Richtung der Schweißnaht S im Bauteil B ausgerichtet, welche Längs-Richtung in der vorliegenden Abbildung aus der Bildebene hinausragt. Das Stegblech T₁ weist eine Dicke b₁ auf, während das Gurtblech T₂ eine Dicke b₂ aufweist. Die beiden Bleche T₁,T₂ schließen miteinander einen Winkel α ein, der im abgebildeten Ausführungsbeispiel als ein rechter Winkel ausgebildet ist.

Durch die Temperatureinwirkung des Schweißguts auf die Bleche T₁,T₂ während des Verschweißens und der Verteilung des Schweißguts im Schweißnahtquerschnitt bilden sich am Schweißnahtübergang und an der Schweißnahtwurzel Kerben aus, die als Ausgangspunkt eines Spannungsrisses dienen können. Um etwa die Ermüdungsfestigkeit des zu bewertenden Querschnitts Q beurteilen zu können wird, wird das an sich bekannte Kerbspannungskonzept herangezogen. Dabei werden die realen Kerben an den Übergängen von den Bleche T₁,T₂ zur Schweißnaht S sowie an der Nahtwurzel im zu bewertenden Querschnitt Q gemäß der Kerbspannungsmethode mit idealisierten, normierten Kerb-Radien K modelliert, in der Abbildung werden dabei die Kerb-Radien K₁ am Schweißnahtübergang und der Kerb-Radius K₂ in der Schweißnahtwurzel unterschieden.

Es versteht sich dabei von selbst, dass beliebige zu bewertende Querschnitte Q von unterschiedlichen Bauteilen B denkbar sind, die mehrere Komponenten T umfassen und bei der eine oder mehr als eine Schweißnaht S zwei oder mehr als zwei Komponenten, etwa Bleche, miteinander verbindet.

Die geometrischen Parameter P des zu bewertenden Querschnitts Q sind dabei im vorliegenden Ausführungsbeispiel: die Dicke b₁ des Stegblechs T₁ als erster Parameter P₁, die Dicke b₂ des Gurtblechs T₂ als zweiter Parameter P₂ und der Winkel α zwischen den beiden Bleche T₁,T₂ als dritter geometrischer Parameter P₃.

Um nun das Meta-Modell erstellen zu können, werden für die einzelnen geometrischen Parameter P₁,P₂,P₃ ein Minimalwert und ein Maximalwert festgelegt, die den Parameterraum R(P₁,P₂,P₃) definieren. Tabelle 1 zeigt beispielhaft die Grenzen eines Parameterraums:

**Tabelle 1**

| Parameter | Minimum | Maximum |
|---|---|---|
| P₁ | 5 mm | 25 mm |
| P₂ | 10 mm | 30 mm |
| P₃ | 60° | 120° |

Innerhalb der Grenzen des Parameterraums R(P₁,P₂,P₃) werden Kombinationen an Werten der geometrischen Parameter P₁,P₂,P₃ definiert, welche jeweils einen Punkt innerhalb des Parameterraums R(P₁,P₂,P₃) darstellen. Da jede dieser Kombinationen einen speziellen zu bewertenden Querschnitt Q charakterisieren, wird aus jedem dieser definierten Punkte ein Querschnitts-Modell D, auch Design genannt, gebildet. Vorzugsweise sind die Querschnitts-Modelle D als FEM, Finite Elemente Methoden, Modelle ausgebildet. Tabelle 2 zeigt einen Auszug mehrerer Querschnitts-Modelle D innerhalb des Parameterraums R(P₁,P₂,P₃).

**Tabelle 2**

| Design | P₁ | P₂ | P₃ |
|---|---|---|---|
| D₁ | 5 mm | 5 mm | 90° |
| D₂ | 5 mm | 20 mm | 90° |
| D₃ | 5 mm | 25 mm | 90° |
| D₄ | 10 mm | 10 mm | 75° |
| D₅ | 10 mm | 15 mm | 75° |
| ... | ... | ... | ... |
| Dₓ | 25 mm | 5 mm | 120° |

Für jedes Querschnitts-Modell D₁...ₓ werden nun Kerbspannungs-Informationen σ_{KI} berechnet. Diese Berechnung kann beispielsweise mittels der Inertia-Relief Methode erfolgen, wie anhand von Figur 2 erläutert wird. Dabei wird als Kerbspannungs-Informationen σ_{KI} ein von Einheitslasten E abhängiges Sub-Modell berechnet, welches unabhängig von einer äußeren Belastung Einheits-Teil-Kerbspannung σ_{TE} für jedes Einheitslast E enthält. Somit lassen sich über das Sub-Modell Kerbspannungen für beliebige Lastzustände berechnen.

Sind die Kerbspannungs-Informationen σ_{KI} für alle Querschnitts-Modell D₁...ₓ berechnet, so stellen die Kerbspannungs-Informationen σ_{KI} die Funktionswerte der durch die Kombination der Werte der geometrischen Parameter P₁,P₂,P₃ definierten Punkte dar. Aus diesen Stützstellen wird nun das Meta-Modell als 3-dimensionale, vorzugsweise stetige, Funktion berechnet. Dabei entsprich die Dimension der Funktion der Anzahl N der geometrischen Parameter P. Vorzugsweise ist das Meta-Modell als NURBS, non uniform rational basis Spline, ausgebildet.

Wird nun eine spezifische Kombination an Werten für die geometrischen Parameter P₁,P₂,P₃ als Argumente an das Meta-Modell übergeben, so stellt der daraus berechnete Funktionswert die Kerbspannungs-Informationen σ_{KI} dieses zu bewertenden Querschnitts Q dar. Zur Verdeutlichung ein kleines Zahlenbeispiel: Wie in Tabelle 2 ersichtlich, wurden nur Kerbspannungs-Informationen σ_{KI} für Querschnitts-Modelle D₁...ₓ in 5 mm Abständen für die Dicken b₁,b₂ und in 15° Schritten für den Winkel α berechnet. Wird nun der Punkt (7,5 mm/12,5 mm/ 85°) als Argument an das Meta-Modell übergeben, stellt der über das Meta-Modell berechnete Funktionswert die Kerbspannungs-Informationen σ_{KI} für genau diesen Punkt dar, ohne dass dafür ein Querschnitts-Modell D erstellt werden muss und daran komplizierte festigkeitstechnische Berechnungen durchgeführt werden müssen.

Mittels des Meta-Modells lassen sich also zumindest für jeden Punkt des Parameterraums R(P₁,P₂,P₃) die entsprechenden Kerbspannungs-Informationen σ_{KI} ableiten.

Die prinzipielle Funktionsweise der Erstellung eines Sub-Modells als Kerbspannungs-Informationen σ_{KI} und die nachfolgende Berechnung eines konkreten zu bewertenden Querschnitts Q unter einer definierten Last Verfahrens wird in Figur 2 schematisch dargestellt:
Dargestellt ist ein zu bewertender Querschnitt Q eines Bauteils B, der rein exemplarisch zur Verdeutlichung der Inertia-Relief Methode ausgewählt ist und eine Schweißnaht S aufweist. Es versteht sich von selbst, dass sich das nachfolgend beschriebene Verfahren auch auf den T-förmigen Querschnitt Q aus Figur 1 bzw. auf einen beliebigen Querschnitt Q mit zwei oder mehreren Schweißnähten S und/oder mehr als zwei Bauteilkomponenten angewendet werden kann. Der Übersichtlichkeit halber wurde auf das Einzeichnen der Kerb-Radien K verzichtet, die nach dem Kerbspannungskonzept ausgewählt sind (siehe Fig. 1).

Die oberste Figur zeigt den zu bewertenden Querschnitt Q, der mit einer ersten Schnittlast L₁ und einer zweiten Schnittlast L₂, wobei beide Schnittlasten L₁,L₂ als Schnittkräfte ausgebildet sind. Die beiden Schnittlasten L₁,L₂ spiegeln den Belastungszustand des zu bewertenden Querschnitt Q wider und wirken als definierte äußere Belastung. Im vorliegenden Fall ist der Belastungszustand durch zwei an den beiden Schnittufern angreifende Schnittkräfte dargestellt, im Allgemeinen sind natürlich auch mehr als zwei Schnittufer, mehr als eine Schnittlast L pro Schnittufer oder äußere Kräfte die, gegebenenfalls auch zusätzlich, auf den zu bewertenden Querschnitt Q wirken, denkbar, die den Belastungszustand des zu bewertenden Querschnitts Q darstellen.

Aus dieser definierten Last resultiert ein Spannungsverlauf V, auf dem die Spannungsberechnung, insbesondere die Berechnung der Kerbspannungen σ_{K}, basiert. Bei dem abgebildeten Belastungszustand bildet sich ein rechteckiger Spannungsverlauf V aus, wobei sich der zu bewertende Querschnitt Q in einem quasi-statischen Gleichgewichtszustand befindet, da sich die beiden Schnittlasten L₁,L₂ gegenseitig aufheben. In anderen Worten befindet sich der zu bewertende Querschnitt Q in Ruhe. Um die nachfolgenden Verfahrensschritte mittels eines Computers durchführen zu können ist es vorteilhaft, wenn der zu bewertende Querschnitt Q durch ein Querschnittsmodell modelliert ist. Bei dem Querschnittsmodell kann es sich beispielsweise um ein FEM-Modell handeln, bei dem die Geometrie des zu bewertenden Querschnitts durch ein Gitternetz mit einer Vielzahl an Knotenpunkten modelliert wird und in jedem Kontenpunkt ein Spannungstensor speicherbar bzw. berechenbar ist.

Die beiden Darstellungen in der Mitte von Figur 2 zeigen nun unter anderem das Wirkungsprinzip der Inertia-Relief Methode: Anstatt Randbedingungen festzulegen und die Verschiebungen zu berechnen, wird der zu bewertende Querschnitt jeweils mit nur einer einzelnen Einheitslast E belastet und ein Beschleunigungsfeld A als Systemantwort auf die Einheitslast E berechnet. In anderen Worten befindet sich der zu bewertende Querschnitt Q in der linken und rechten mittleren Abbildung nicht wie in der oberen Abbildung in Ruhe, sondern befindet sich in einem Zustand der konstanten Beschleunigung. Während das Beschleunigungsfeld A zum besseren Verständnis der Methode als Pfeil dargestellt ist, versteht es sich von selbst, dass das Beschleunigungsfeld A als Beschleunigungsvektoren und/oder Beschleunigungstensoren in den einzelnen Knotenpunkten des Querschnittsmodells berechnet und dargestellt werden kann.

Theoretisch wäre es natürlich möglich, die Beschleunigungsfelder A direkt für die entsprechende Schnittlasten L zu berechnen. Erfindungsgemäß ist jedoch vorgesehen, dass die Berechnung der Beschleunigungsfelder A von der tatsächlichen Belastung des zu bewertenden Querschnitts Q entkoppelt ist. Während in der vorliegenden vereinfachten Prinzip-Darstellung die erste Schnittkraft L₁ und die erste Einheitskraft E₁ bzw. die zweite Schnittkraft L₂ und die zweite Einheitskraft E₂ gleichgerichtet sind und sich nur betragsmäßig unterscheiden, kann in einem allgemeinen zweidimensionalen Belastungszustand die tatsächliche Belastung durch zwei linear unabhängige Einheitskräfte und ein Einheitsmoment dargestellt werden.

Durch die Entkoppelung der tatsächlich auf den zu bewertenden Querschnitt Q wirkenden Last und der dem jeweiligen Beschleunigungsfeld A zugrunde liegende Einheitslast E wird erfindungsgemäß ein Sub-Modell erstellt, welches es ermöglicht, die Ergebnisse der Inertia-Relief Methode in einfacher Art und Weise für die Berechnung einer Vielzahl an unterschiedlichen Belastungsfällen anwenden zu können.

Die Erstellung des Sub-Modells für ein Querschnitts-Modell D soll in der Folge kurz erläutert werden. Zum einfacheren Verständnis, sind die geometrischen Parameter P des Sub-Modells ident mit denen des zu bewertenden Querschnitts Q. Tatsächlich wird jedoch, wie eingangs beschrieben, ein Sub-Modell für jedes Querschnitts-Modell D berechnet und das Sub-Modell für den tatsächlich belasteten zu bewertenden Querschnitt Q erst nach der Berechnung des Meta-Modells aus diesem abgeleitet.

In der linken mittleren Abbildung in Fig. 2 ist der zu bewertende Querschnitt Q des Querschnitts-Modells D mit der ersten Einheitslast E₁ belastet und das erste Beschleunigungsfeld A₁ wird computergestützt als Systemantwort des zu bewertenden Querschnitts Q des Querschnitts-Modells D auf die durch die erste Einheitslast E₁ bedingte Beschleunigung berechnet. Daraus resultiert ein erster Spannungsverlauf V₁, der dreiecksförmig ausgebildet ist und sein Maximum am Angriffspunkt der ersten Einheitslast E₁, also am ersten Schnittufer, aufweist. Auf Basis dieses ersten Beschleunigungsfelds A₁ wird danach eine erste Einheits-Teil-Kerbspannung σ_{TE}(E₁) aufgrund der ersten Einheitslast E₁ berechnet, die insbesondere für die nicht dargestellten Kerb-Radien K berechnet werden. Beispielsweise kann die erste Einheits-Teil-Kerbspannung σ_{TE}(E₁) einen skalaren Wert oder eine Spannungsvektor oder einen Spannungstensor für jeden die Kerb-Radien K ausbildenden Knotenpunkt des Querschnittsmodells umfassen.

In analoger Art und Weise wird in der rechten mittleren Abbildung das zweite Beschleunigungsfeld A₂ als Systemantwort auf die zweite Einheitslast E₂ berechnet, wobei sich wiederum ein dreiecksförmiger zweiter Spannungsverlauf V₂ ausbildet, der sein Maximum am zweiten, dem ersten gegenüberliegenden, Schnittufer aufweist. Nachfolgend wird eine zweite Einheits-Teil-Kerbspannung σ_{TE}(E₂) aufgrund der zweiten Einheitslast E₂, analog zur oben beschriebenen Berechnung der ersten Einheits-Teil-Kerbspannung σ_{TE}(E₁), berechnet.

Während die Berechnung der Einheits-Teil-Kerbspannung σ_{TE} im vorliegenden Beispiel damit beendet ist, müssten, um einen allgemeinen Belastungszustand darstellen zu können, noch an jedem Schnittufer die Einheits-Teil-Kerbspannungen σ_{TE} aufgrund einer linear unabhängigen, vorzugsweise vertikal gerichteten, Einheitskraft und eines Einheitsmoments in analoger Art und Weise berechnet werden. Damit ist die Erstellung des Sub-Modells abgeschlossen.

Dieser Vorgang wird für alle Querschnitts-Modelle D₁...ₓ wiederholt, wobei die Sub-Modelle als Kerbspannungs-Informationen σ_{KI} der Querschnitts-Modelle D₁...ₓ fungieren. Nachdem das Meta-Modell erstellt wurde, werden die Werte der geometrischen Parameter P des tatsächlich zu bewertenden Querschnitts Q an das Meta-Modell als Argumente übergeben und das Sub-Modell als Kerbspannungs-Informationen σ_{KI} des zu bewertenden Querschnitts Q über das Meta-Modell berechnet.

Um nun die Kerbspannung σ_{K} aufgrund der tatsächlichen Belastungssituation des zu bewertenden Querschnitts Q berechnen zu können, ist es nunmehr notwendig, die Einheits-Teil-Kerbspannungen σ_{TE} des Sub-Modells derart anzupassen, dass sie die Belastung des zu bewertenden Querschnitts Q durch die Schnittlasten L widerspiegelt (siehe oberste Abbildung in Figur 2). Da die Einheits-Teil-Kerbspannungen σ_{TE} auf jeweils einer Einheitslast E basieren, müssen also nur die Schnittlasten L durch die Einheitslasten E dargestellt werden. Dazu wird für jede Einheitslast E ein entsprechender Linearkombinations-Faktor n berechnet. So lässt sich die erste Schnittlast L₁ durch Multiplikation der ersten Einheitslast E₁ mit einem ersten Linearkombinations-Faktor n₁ darstellen und die zweite Schnittlast L₂ durch Multiplikation der zweiten Einheitslast E₂ mit einem zweiten Linearkombinations-Faktor n₂. Da die Einheits-Teil-Kerbspannung σ_{TE}(E₁), σ_{TE}(E₂) direkt proportional zu den ihnen zugrunde liegenden Einheitslasten E₁,E₂ sind, lassen sich mithilfe der Linearkombinations-Faktor n₁,n₂ auch die Teil-Kerbspannungen σ_{T1},σ_{T2} berechnen, wobei die erste Teil-Kerbspannung σ_{T1} aus der Multiplikation der ersten Einheits-Teil-Kerbspannung σ_{TE}(E₁) mit dem ersten Linearkombinations-Faktor n₁ und die zweite Teil-Kerbspannung σ_{T2} aus der Multiplikation der zweiten Einheits-Teil-Kerbspannung σ_{TE}(E₂) mit dem zweiten Linearkombinations-Faktor n₂ resultiert. Die tatsächliche Kerbspannung σ_{K} wird schlussendlich durch die Superposition der beiden Teil-Kerbspannungen σ_{T1},σ_{T2} berechnet. Die beiden Beschleunigungsfelder A heben sich dabei bei der Superposition gegenseitig auf, sodass sich der zu bewertende Querschnitt Q nach der Linearkombination und Superposition wieder in Ruhe befindet.

Wie die untere Abbildung in Figur 2 zeigt, entspricht der aus der Linearkombination der Einheitslasten E resultierende Spannungsverlauf V dem realen Spannungsverlauf V der oberen Abbildung ohne dass bei der Berechnung eine Annahme über die Randbedingungen getroffen werden musste. Somit spiegeln die mit Hilfe des Sub-Modells berechneten Kerbspannungen σ_{K} den tatsächlichen Kraftfluss im zu bewertenden Querschnitt Q wider und können so als analytische Lösung des mechanischen Problems gesehen werden.

Ein weiterer großer Vorteil des Verfahrens liegt nun darin, dass die komplexe Berechnung der Einheits-Teil-Kerbspannungen σ_{TE} nur bei der Erstellung des Sub-Modelle für die Querschnitts-Modelle D notwendig ist, denn die Sub-Modelle für beliebige Punkte können mittels des Meta-Modells berechnet werden. Ein Sub-Modell für einen zu bewertenden Querschnitt ist jedoch für die Berechnung der Kerbspannungen σ_{K} für eine beliebige Anzahl an Lastfällen geeignet, wobei lediglich die weit weniger rechenintensiven Schritte der Bestimmung der Linearkombinations-Faktoren sowie die Linearkombination der Einheits-Teil-Kerbspannungen σ_{TE} und schließlich die Superposition derselben notwendig ist.

Um zu überprüfen, ob das Sub-Modell korrekt erstellt ist und die Linearkombination der Einheitslasten tatsächlich den Belastungszustand widerspiegelt, wird vor der Berechnung der Kerbspannungen σ_{K} überprüft, ob die Summe der linearkombinierten Einheitslasten E sich in einem Gleichgewichtszustand befinden. Wenn kein Gleichgewichtszustand vorliegt, so muss die Berechnung unterbrochen werden und der Anwender eine Mitteilung erhalten, dass ein Berechnungsfehler vorliegt und die Eingaben zu überprüfen sind.

Obwohl die Erfindung in Detail durch oben dargestellte bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden ohne den Schutzumfang der Erfindung zu verlassen.

### Bezugszeichenliste:

- A: Beschleunigungsfeld
- b₁: Dicke des Stegblechs T₁
- b₂: Dicke des Gurtblechs T₂
- B: Bauteil
- E: Einheitslast
- K: Kerb-Radius
- K₁: Kerb-Radius am Schweißnahtübergang
- K₂: Kerb-Radius in der Schweißnahtwurzel
- L₁: Schnittlast
- L₂: Schnittlast
- P: geometrische Parameter
- Q: zu bewertender Querschnitt
- S: Schweißnaht
- T₁: Stegblech
- T₂: Gurtblech
- V: Spannungsverlauf
- α: Winkel zwischen Stegblech T₁ und Gurtblech T₂

## Patentansprüche

1. Verfahren, durchgeführt mittels eines Computers, zur Erstellung eines Meta-Modells zur Berechnung von Kerbspannungen (σ_{K}(B_{1...m})) für einen zu bewertenden Querschnitt (Q_{1...m}) einer Vielzahl an zumindest eine Schweißnaht (S) mit einer Kerbe aufweisenden Bauteilen (B_{1...m}), wobei der zu bewertende Querschnitt (Q_{1...m}) jedes Bauteils (B_{1...m}) durch eine spezifische Kombination aus N den zu bewertenden Querschnitt (Q_{1...m}) des Bauteils (B_{1...m}) charakterisierenden geometrischen Parametern (P_{1...N}) und deren konkrete Werte definiert ist, wobei folgende Verfahrensschritte durchgeführt werden:
- Definition eines N-dimensionalen Parameterraums (R(P₁,...,P_{N})) durch Festlegen eines Minimalwerts und eines Maximalwerts für jeden der geometrischen Parameter (P_{1...N}) ;
- Erstellen einer diskreten Anzahl an Querschnitts-Modellen (D_{1...x}), wobei jedes Querschnitts-Modell (D_{1...x}) einem diskreten Punkt des Parameterraums (R(P₁,...,P_{N})) entspricht und die Kerbe der zumindest einen Schweißnaht (S) im Querschnitts-Modell (D_{1...x}) durch einen nach dem Kerbspannungskonzept ausgewählten Kerb-Radius (K) ersetzt wird;
- Berechnung von Kerbspannungs-Informationen (σ_{KI}(D₁),..., σ_{KI}(Dₓ)) für jedes Querschnitts-Modell (D_{1...x}) als Funktionswert einer durch das jeweilige Querschnitts-Modell (D_{1...x}) bestimmten Stützstelle;
- Erstellen des Meta-Modells in Form einer N-dimensionalen, vorzugsweise stetigen, Funktion, wobei die Funktionswerte des Meta-Modells an den Stützstellen an die Funktionswerte der Stützstellen selbst angenähert werden,
sodass mittels des Meta-Modells Kerbspannungs-Informationen (σ_{KI}(Q_{1...m})) als Funktionswerte des Meta-Modells berechnet werden, wenn eine spezifische Kombination an Werten der den zu bewertenden Querschnitt (Q_{1...m}) eines Bauteils (B_{1...m}) charakterisierenden geometrischen Parametern (P_{1...N}) als Argumente an das Meta-Modell übergeben werden.

2. Verfahren nach Anspruch 1, **dadurch gekennzeichnet, dass** die geometrischen Parameter (P_{1...N}) zumindest eine, vorzugsweise eine Kombination mehrerer, der nachfolgenden Informationen umfasst:
Abmessungen der einzelnen den zu bewertenden Querschnitt (Q_{1...m}) bildenden Komponenten des Bauteils (B_{1...m}), relative Position der Komponenten zueinander, geometrische Parameter des Querschnitts der Schweißnaht (S).

3. Verfahren nach einem der Ansprüche 1 oder 2, **dadurch gekennzeichnet, dass** im Parameterraum (R(P₁,...,P_{N})) Zwischenwerte zwischen dem Minimalwert und dem Maximalwert der geometrischen Parameter (P_{1...N}) derart verteilt werden, dass genügend Querschnitts-Modelle (D_{1...x}) als Stützstellen zur Erstellung des als N-dimensionale Funktion ausgebildeten Meta-Modells zur Verfügung stehen.

4. Verfahren nach einem der Ansprüche 1 bis 3, **dadurch gekennzeichnet, dass** die Annäherung der Funktionswerte des Meta-Modells an die Funktionswerte der Stützstellen mittels eines iterativen Optimierungsverfahrens erfolgt.

5. Verfahren nach einem der Ansprüche 1 bis 4, **dadurch gekennzeichnet, dass** die Querschnitts-Modelle (D_{1...x}) als FEM-, Finite Elemente Methoden, Modelle erstellt werden.

6. Verfahren nach einem der Ansprüche 1 bis 5, **dadurch gekennzeichnet, dass** als Kerbspannungs-Informationen (σ_{KI}(D₁),...,σ_{KI}(Dₓ)) für jedes Querschnitts-Modell (D) Einheits-Teil-Kerbspannungen (σ_{TE}(E₁),...,σ_{TE}(E_{y})) für definierte Einheitslasten (E_{1...y}), vorzugsweise mittels der Inertia-Relief Methode, berechnet werden.

7. Verfahren nach Anspruch 6, **dadurch gekennzeichnet, dass** die Einheitslasten (E_{1...y}) als linear unabhängige Einheitskräfte und/oder Einheitsmomente ausgebildet sind, sodass sich beliebige Lastzustände am zu bewertenden Querschnitt (Q_{1...m}) eines Bauteils (B_{1...m}) als Linearkombination der Einheitslasten darstellen lassen.

8. Verfahren nach einem der Ansprüche 1 bis 5, **dadurch gekennzeichnet, dass** als Kerbspannungs-Informationen (σ_{KI}(D₁),...,σ_{K}(Dₓ)) für jedes Querschnitts-Modell (D_{1...x}) die aus einer an den Querschnitts-Modellen (D_{1...x}) angreifenden Last resultierenden Kerbspannungen berechnet werden.

9. Verfahren nach einem der Ansprüche 1 bis 8, **dadurch gekennzeichnet, dass** das Meta-Modell als N-dimensionale nicht lineare rationale Basis-Splines abgebildet wird.

10. Verfahren nach einem der Ansprüche 1 bis 9, **dadurch gekennzeichnet, dass** das Meta-Modell nach der Erstellung in einem nicht temporären Speicher gespeichert wird.

11. Verfahren zur Ermittlung von Kerbspannungen (σ_{K}(B_{1...m})) für einen zu bewertenden Querschnitt (Q_{1...m}) eines zumindest eine Schweißnaht (S) mit einer Kerbe aufweisenden Bauteils (B_{1...m}) mit dem nach einem der Ansprüche 1 bis 10 erstellten Meta-Modell,
wobei der zu bewertende Querschnitt (Q_{1...m}) des Bauteils (B_{1...m}) durch eine spezifische Kombination an geometrischen Parametern (P_{1...N}) und deren konkrete Werte definiert ist und durch eine definierte Last belastet ist, wobei folgende Verfahrensschritte durchgeführt werden:
- Übergeben der Werte der geometrischen Parameter (P_{1...N}) als Argumente an das Meta-Modell;
- Berechnen der Kerbspannungs-Informationen (σ_{KI}(B_{1...m})) des zu bewertende Querschnitts (Q_{1...m}) mittels des Meta-Modells als Funktionswert der übergebenen Werte der geometrischen Parametern (P_{1...N});
- Berechnen der Kerbspannungen (σ_{K}(Q_{1...m})) des zu bewertenden Querschnitts (Q_{1...m}) des Bauteils (B_{1...m}) aus den Kerbspannungs-Informationen (σ_{KI}(Q_{1...m})).

12. Verfahren nach Anspruch 11, **dadurch gekennzeichnet, dass** die an das Meta-Modell übergebenen Werte der geometrischen Parameter (P_{1...N}) innerhalb der Grenzen der definierten Parameterräume ((R(P₁,...,P_{N}))) des jeweiligen geometrischen Parameters (P_{1...N}) liegen.

13. Verfahren nach Anspruch 11 oder 12, **dadurch gekennzeichnet, dass** die Kerbspannungs-Informationen (σ_{KI}(B_{1...m})) in Form eines aus dem Meta-Modell abgeleiteten, die Einheits-Teil-Kerbspannungen (σ_{TE}(E₁),..., σ_{TE}(E_{y})) und die den Einheits-Teil-Kerbspannungen (σ_{TE}(E₁),...,σ_{TE}(E_{y})) zugrunde liegenden Einheitslasten (E_{1...y}) enthaltenden, Sub-Modells ausgegeben werden, wobei mittels der Einheits-Teil-Kerbspannungen (σ_{TE}(E₁),...,σ_{TE}(E_{y})) die Kerbspannungen (σ_{K}(B_{1...m})) des Bauteils (B_{1...m}) für beliebige Lastzustände berechnet werden können.

14. Verfahren nach Anspruch 13, **dadurch gekennzeichnet, dass** folgende Verfahrensschritte ausgeführt werden:
- Bestimmen von Linearkombinations-Faktoren für den zu berechnenden Lastzustand, wobei die den Kerbspannungen (σ_{K}(Q_{1...m})) zugrunde liegenden Schnittlasten als Linearkombination der Einheitslasten (E_{1...y}) dargestellt werden;
- Multiplizieren der Linearkombinations-Faktoren mit den jeweils der entsprechenden Einheitslast (E_{1...y}) zugeordneten Einheits-Teil-Kerbspannungen (σ_{TE}(E₁),...,σ_{TE}(E_{y}))
- Superposition der einzelnen Produkte von Einheits-Teil-Kerbspannungen (σ_{TE}(E₁),...,σ_{TE}(E_{y})) und Linearkombinations-Faktoren.

15. Computerprogrammprodukt, welches ein Programm umfasst und direkt in einen Speicher eines Rechners ladbar ist, mit Programm-Mitteln, um alle Schritte des Verfahrens nach einem der Ansprüche 1 bis 14 auszuführen, wenn das Programm vom Rechner ausgeführt wird.
